Europäisches Patentamt

**European Patent Office**

Office européen des brevets

(19)

(11) Numéro de publication: **0 309 376**
A2

(12)

# DEMANDE DE BREVET EUROPEEN

(21) Numéro de dépôt: 88500087.7

(22) Date de dépôt: 21.09.88

(51) Int. Cl.⁴: **H 05 K 3/02**
H 05 K 3/20, B 32 B 31/20

(30) Priorité: 21.09.87 ES 8702842

(43) Date de publication de la demande:
29.03.89 Bulletin 89/13

(84) Etats contractants désignés: **CH DE FR LI**

(71) Demandeur: **PROMEX, S.A.**
**Rue Progreso n. 245-269**
**E-08912 Badalona Barcelona (ES)**

(72) Inventeur: **Reber Linsner, Wolfgang**
**Rosario N. 23**
**E-08017 Barcelona (ES)**

(74) Mandataire: **Manresa Val, Manuel**
**Gerona n. 34**
**E-08010 Barcelona (ES)**

(54) **Procédé de fabrication de câblage imprimé raide, mono ou multicouche.**

(57) Procédé de fabrication de câblage imprimé raide, mono ou multicouche, caractérisé en ce que pour obtenir le support isolant et l'isolation entre pistes conductrices, à partir d'une natte en fibres de renfort, imprégnée de résines (sheet moulding compound, SMC) la matrice étant en résines duroplastiques ou thermoplastiques, effectuant l'union de ladite natte en fibres de renfort, imprégnée, SMC, à une lame conductrice, par exemple en cuivre, d'une grosseur quelconque en une seule opération de moulage sous pression, avec apport de chaleur, en utilisant des moules substantiellement lisses, contre lesquels s'appuie la feuille en cuivre et la natte de fibres, superposées, le renfort de fibres restant inaltérable durant le moulage, sans bris de celles-ci par contraintes mécaniques et le temps de moulage étant comprise entre 15 secondes et 1 minute.

EP 0 309 376 A2

**Description**

## Procédé de fabrication de câblage imprimé raide, mono ou multicouche

Le présent brevet d'invention concerne à un procédé de fabrication de câblage imprimé raide, mono ou multicouche, à application spéciale pour produire un câblage imprimé raide, à forte résistence mécanique (stable face aux vibrations) et électrique, et pour ce apte en particulier pour son utilisation dans l'industrie de l'automobile, et dans des moyens de transport en général, où les plaques de circuit imprimé, doivent résister des sollicitations mécaniques intenses.

Le procédé objet de ce brevet d'invention, concerne en essence un processus pour former le support diélectrique et son union à la couche conductrice, en y formant les chemins ou régions isolantes entre les pistes conductrices du branchement imprimé. Le procédé permet d'utiliser une lame conductrice, par exemple en cuivre, d'une grosseur quelconque, prépoinçonnée ou pas, la technologie de gravure de ladite couche conductrice, étant du type conventionnel.

Il existe actuellement une grande variété de matériaux pour former les plaques isolantes. De tous ces matériaux les plus vastement utilisés sont le papier aggloméré avec des résines phénoliques et la fibre de verre agglomérée avec des résines époxydes. Les matériaux à base de verre ont les meilleures caractéristiques, mais ils sont plus chers.

Par ailleurs, les caractéristiques principales que doivent remplir les supports isolants, utilisés comme base d'un câblage imprimé raide ont été bien définies, et sont résumées ci-dessous, schématiquement:
- résistance aux sollicitations mécaniques (plus ou moins grande selon la fonction à réaliser)
- résistance aux sollicitations électriques
- facilité pour son usinage
- ne pas être fragile
- libérer facilement la chaleur absorbée
- ne pas absorber l'humidité
- être économiquement accessible
Les matériaux cités auparavant remplissent suffisament les exigences que l'on vient de citer, et seulement pour des applications spéciales de haute fréquence et de températures élevées, on utilise des matériaux tels que le téflon et d'autres plastiques massifs.

Selon un autre procédé, également mis en pratique en ce moment, le câblage imprimé est obtenu en partant d' une grosse lame en cuivre prépoinçonnée, qui est disposée dûment soutenue, entre deux moules spéciaux, qui reproduisent des figures, en procédant à un moulage par injection qui remplit avec un isolant les rainures de la plaque et forme des configurations en saillie isolantes sous ses deux faces, en délimitant les pistes conductrices.

Nous décririons ci-dessous, en détail, les deux procédés de fabrication cités, afin de pouvoir comprendre les différences et l'importance de l'invention proposée.

La fabrication de ces plaques isolantes à base de papier ou de fibre de verre commence par imprégner avec de la résine agglomérante les rouleaux de matériau de renfort (le papier ou la fibre de verre). Après les avoir imprégnés, le matériau passe par des rouleaux qui éliminent l'excès de résine puis est semi-durci dans une longue étuve sécheuse, par la chaleur. Ensuite, ce matériau semi-durci, est coupé en morceaux, qui sont empilées avec les feuilles en cuivre laminé recouvertes d'adhésif et sont comprimés jusqu'à les réduire à l'épaisseur qu'il faut pour les plaques du circuit de branchements imprimés, dans une presse qui les soumet durant une heure ou plus, à des températures de l'ordre de 170oC et des pressions de l'ordre d'environ 103 Kg/cm$^2$.

Une fois formée l'union du support avec la feuille en cuivre laminé, on grave sur la face libre de ladite feuille, du câblage imprimé, d'après la méthodologie conventionnelle, qui comporte une aggression de la couche de Cu, en préservant avec des moyens de protection appropriés, les régions destinées à constituer les pistes conductrices.

Ce procédé permet d'utiliser une feuille en cuivre très mince, de l'ordre de dizièmes de millimètre en fournis sant l'isolant straitifié la résistance mécanique exigée.

On obtient ainsi un câblage imprimé où il existe un petit ressaut entre la stratification de base, isolante, et le cuivre, qui, quoique, en général, cela n'a aucune importance, dans certains cas, comme pour employer le circuit comme commutateur ou pour un delco codifié, n'est pas admissible.

Dans ces circonstances on utilise ensuite une technologie dénommée "flushing", consistant à placer le câblage imprimé terminé, sans les composants qu'il doit comporter, dans une presse chauffée et exercer une forte pression avec quoi on fait pénétrer les bandes de Cu, dans la stratification. La stratification est placée dans la presse entre une feuille en acier inoxydable, en contact avec le cuivre et une autre en aluminium en contact avec l'isolant. On place d'un côté et d'autre des feuilles en papier et on soumet l'ensemble à une pression qui varie de 70 a 200 Kg/cm$^2$ et des températures de 150 a 175oC, durant 15 ou 20 minutes, selon les limites du type de stratification.

Il est évident que le procédé qui vient d'être exposé est cher, à cause de sa complexité, des moyens à employer et, en particulier, du temps qu'il faut pour sa termination.

Alternativement, le deuxième procédé qui a été cité comme faisant partie de l'état de la technique, c'est-à-dire l'obtention de la plaque de circuit imprimé par moulage par injection, si bien il est un processus rapide, il résulte également un procédé très cher, car il faut utiliser des moules spéciaux très coûteux, où sont configurés en négatifs les chemins ou zones isolantes entre les pistes, et donc il faudra une paire de moules spécifiques pour chaque type de câblage imprimé à exécuter. En outre, l'opératoire est complexe, demandant des moyens de positionnement et de soutien de la lame en cuivre entre les deux moules, dans une situation spéciale très exacte. Dans ce procédé, par ailleurs, il faut nécessairement partir d'une lame en cuivre pré-poinçonnée et il faut qu'elle ait une grosseur notable (et donc un prix élevé) si on pense que l'ensemble du câblage imprimé terminé doit résister des sollicitations mécaniques intenses telles que les inhérentes aux vibrations voisines de son point d'installation. C'est dû au fait que le matériau isolant ne peut pas constituer un véritable support, car à cause du processus d'injection (passage du matériau à fibres courtes de renfort, par le conduit d'injection et par le bec), il se produit en une proportion élevée le bris de fibres de renfort du matériau employé, ce qui diminue considérablement la résistance mécanique du câblage imprimé, il faut qu'elle soit obtenue dans cette méthode, en grande partie, à partir de celle fournie par la propre lame en cuivre qui est autoportante, et ce aux dépens d'accroître sensiblement le coût d'obtention de l'ensemble du circuit imprimé.

Il est donc évident qu'il fallait trouver un procédé alternatif aux deux exposés, dans lequel on pourra réunir leurs avantages en palliant leurs inconvénients et obtenir basiquement un temps de fabrication bas, similaire au type du deuxième procédé, en même temps que le résultat de solidité mécanique caractéristique du premier, et c'est là l'objet du présent brevet d'invention.

Le procédé préconisé, est indentifié face aux deux cités jusqu'à ce point, en ce qu'il emploie un matériau de départ différent, qu'il consiste en une opération de moulage de courte durée, mais sans moules spéciaux et spécifiques pour chaque sorte de circuit, et en conservant durant le moulage la résistance de la fibre qui pourra être de plus une fibre plus longue que pour le deuxième procédé considéré.

En essence la procédé concerné par ce brevet, est caracterisé en ce que la plaque isolante de support et l'isolation entre pistes conductrices du branchement imprimé, sont obtenues à partir d'une natte de fibres de renfort, imprégnée de résines appropriées, c'est-à-dire en terminologie technique du secteur, un "sheet moulding compound" ou en abréviation "SMC". les résines employées peuvent être par exemple des résines de polyesters non saturés; sans qu'on l'entende en sens limitatif, la matrice étant en résines duroplastiques ou thermoplastiques et en arrivant en fonction de la résine choisie à des supports aux caractéristiques techniques spécifiques permettant d'obtenir des types à la résistance mécanique, chimique et thermique très élevée. Ladite natte des fibres de renfort, imprégnée ou SMC, est unie à une lame en cuivre ou autre matériau conducteur qui peut être d'une grosseur quelconque, dans une unique opération de moulage de courte durée, le renfort de fibres restant inaltéré pendant le temps de moulage, sans aucun bris de celles-ci par contraintes mécaniques et sans qu'il faille utiliser des moules spéciaux, spécifiques pour chaque sorte de câblage imprimé à fabriquer, ni partir nécessairement de lame de matériau conducteur pré-poinçonnée.

Le processus pourra être réalisé de façon continue ou séquentielle, car ses caractéristiques le permettent.

L'opération d'union entre la lame en cuivre et la natte de fibres imprégnée de résine, SMC, est réalisée par un moulage à pression, avec apport de chaleur, en utilisant des moules substantiellement lisses, contre lesquels s'appuie la feuille en cuivre et la natte de fibres, respectivement, superposées, avec une durée moyenne du processus d'environ 15 secondes à une minute, qui ne doit pas être interprétée non plus en sens limitatif mais seulement à titre d'orientation et ce processus pouvant être exécuté de façon continue ou séquentielle.

La procédé préconisé permet, tel qu'il a été dit auparavant, d'employer de lames en cuivre très minces (de l'ordre de dizième de millimètre), et dans ce cas on munit chacune d'elles sur une de ses faces, d'un mince support de renfort, pour la conserver correctement étirée et/ou étendue, ce support agissant en tant que protection du circuit et pouvant être retiré avant son utilisation ou à une autre étane du processus (par exemple pour graver le circuit de branchement), très facilement.

Si l'on part d'une plaque en cuivre pré-poinçonnée, dont la grosseur peut également être minimale, avec définition de rainures qui correspondent avec les espaces entre les pistes conductrices, lesdites rainures restent, après l'étape de moulage citée, remplies de matériau d'apport formant le support isolant, et les surfaces conductrices et d'isolant, de séparation de celles-ci, elles restent dans ce cas, substantiellement coplanaires, en permettant l'obtention de câblage imprimé raide, extraplat, lisse, sans avoir besoin d'une opération ultérieure de flushing. Ensuite on procedera à un poinçonnage final selon la technique conventionnelle. C'est-à-dire dans ce cas aussi bien le support que l'isolation entre les pistes, sont substantiellement obtenus en une seule opération rapide et de coût bas.

Si la lame en cuivre est complètement lisse, le procédé qui est proposé fournit un résultat pratiquement équivalent à celui du premier procédé cité, quoique avec un temps de fabrication très inférieur, et une fois finie l'opération d'union à ladite lame conductrice de la natte de fibres imprégnés de résine ou SMC, on procédera à graver le circuit de branchements sur sa face opposée libre, au moyen de métodologie classique.

Le procédé de fabrication concerné par cette description étant suffisamment décrit de sorte que son objet soit compréhensible pour un technicien en la matière qui pourrait le mener à la pratique, il est demandé d'étendre son objet aux variations de détail n'en altérant pas l'essentialité , qui sont résumées dans ses conditions de nouveauté aux revendications suivantes qui font le résumé et sont le complément de la description ci-avant.

**Revendications**

1. Procédé de fabrication de câblage imprimé raide, mono ou multicouche, d'application spéciale pour produire un câblage imprimé raide, d'une résistance mécanique élevée, stable face aux vibrations, caractérisé en ce que la plaque isolante de support et l'isolation entre les pistes conductrices du branchement imprimé, sont obtenues à partir d'une natte en fibres de renfort, imprégnée de résines appropriées (sheet moulding compound SMC), telles que des résines en polyesters non saturées, la matrice étant en résines duroplastiques ou thermoplastiques, en obtenant en fonction de la résine choisie, des supports aux caractéristiques techniques spécifiques permettant d'obtenir des types à la résistance mécanique, chimique et thermique très élevée, et en ce que ladite natte de fibres de renfort imprégnée, SMC, est unie à une lame conductrice, par exemple en cuivre, qui peut être d'une grosseur quelconque, dans une seule opération de moulage à courte durée, exécutée en un processus continu ou séquentiel, le renfort en fibres restant inaltéré durant le temps de moulage, sans qu'elles ne se brisent par contraintes mécaniques.

2.- Procédé de fabrication de câblage imprimé raide, mono ou multicouche, selon la revendication précédente et en ce que l'opération d'union entre la lame en Cu et la natte en fibres imprégnée de résine, est opérée par un moulage à pression, avec apport de chaleur, en utilisant des moules, substantiellement lisses, contre lesquels s'appuientla feuille en cuivre et la natte en fibres, respectivement, superposées, avec une durée moyenne du processus d'environ 15 secondes à une minute.

3.- Procédé de fabrication de câblage imprimé raide, mono ou multicouche, selon les revendications précédentes et en ce qu'on emploie une lame en cuivre très mince (de l'ordre de dizièmes de mm) qui est munie sur une de ses faces, d'un mince support de renfort, pour la conserver correctement étirée et/ou étendue, ledit support agissant en tant que protection de la lame en cuivre, durant la manipulation du circuit et pouvant être retiré avant son utilisation ou à une autre étape du processus, très facilement.

4.- Procédé de fabrication de câblage imprimé raide, mono ou multicouche, selon les revendications précédentes et en ce que l'on part d'une lame en cuivre qui a été prépoinçonnée, conformément aux caractéristiques de desing du câblage imprimé, avec définition de rainures en correspondance avec les espaces entre pistes conductrices, lesdites rainures restent remplies du matériau d'apport, qui forme le support isolant et les surfaces des pistes conductrices et de l'isolant de séparation de celles-ci, restent substantiellement coplanaires, en procédant ultérieurement à un poinçonnage final.

5.- Procédé de fabrication de câblage imprimé raide, mono ou multicouche, selon les revendications précédentes et en ce que l'on part d'une lame en cuivre complètement lisse, et dans ce cas et une fois terminée l'opération d'union à celle-ci de la natte en fibres, on procède à graver le circuit de branchements, sur sa face opposée, par méthodologie conventionnelle.